# FASCICULE DE BREVET EUROPEEN

(11) **EP 1 109 221 B1**
(45) Date de publication et mention de la délivrance du brevet: **02.11.2006**
(21) Numéro de dépôt: 00403464.1
(22) Date de dépôt: 11.12.2000
(51) Int. Cl.: H01L 23/532, H01L 21/768

(54) **Structure d'interconnexions de type damascène et son procédé de réalisation**
Damaszene Verbindungsstruktur und ihr Herstellungsverfahren
Damascene interconnection structure and method for forming the same

(30) Priorité: 13.12.1999 FR 9915669
(43) Date de publication de la demande: 20.06.2001
(73) Titulaire: STMicroelectronics S.A., 92120 Montrouge (FR)
(72) Inventeur: Passemard, Gérard, 38660 Lumbin (FR)
(74) Mandataire: Poulin, Gérard

(56) Documents cités:
- EP-A- 0 960 958
- PING XU ET AL: "BLO kappa -a low- kappa dielectric barrier/etch stop film for copper damascene applications" INSPEC, XP002129704
- KORCZYNSKI E: "LOW-K DIELECTRIC COSTS FOR DUAL-DAMASCENE INTEGRATION" SOLID STATE TECHNOLOGY,US,COWAN PUBL.CORP. WASHINGTON, vol. 42, no. 5, mai 1999 (1999-05), pages 43-44,46,49,51, XP000822946 ISSN: 0038-111X

## Description

### DOMAINE TECHNIQUE

La présente invention concerne une structure d'interconnexions de type Damascène. Elle concerne aussi son procédé de réalisation.

### ÉTAT DE LA TECHNIQUE ANTÉRIEURE

Les structures d'interconnexions des circuits intégrés sont conventionnellement réalisées en aluminium dopé par du cuivre (Al-Cu), le taux de dopage étant de l'ordre de 2 à 4%. Le procédé employé pour réaliser ces structures d'interconnexions consiste à déposer le métal, puis à le graver pour former le réseau des interconnexions et enfin à déposer, pardessus, un diélectrique qui sert à isoler les lignes de métal aussi bien latéralement (isolation inter-lignes) que verticalement (isolation inter-niveaux). Ce procédé est communément appelé "conventionnel" ou "gap fill" (remplissage des espaces inter-lignes par le diélectrique).

L'amélioration des performances des circuits (vitesse, faible consommation) a nécessité l'emploi de métaux plus conducteurs et de matériaux à faible permittivité. Pour la métallisation, le cuivre, qui possède une résistivité environ deux fois plus faible que Al-Cu, est apparu comme le meilleur candidat. Cependant, l'emploi du cuivre ne peut pas s'envisager dans une structure conventionnelle car la gravure de ce matériau est très difficile. C'est pourquoi il est employé dans une structure dite Damascène.

Dans une structure Damascène, le réseau des interconnexions est formé par gravure de tranchées dans un diélectrique à très faible permittivité, puis par dépôt d'une couche barrière en nitrure métallique suivi du remplissage de la tranchée par du cuivre. En dernier lieu, l'excès de cuivre et de matériau barrière est éliminé par polissage afin de ne laisser que le diélectrique entre les lignes de métal. La réalisation d'une telle structure nécessite l'emploi de couches de matériau diélectrique d'interface à usage de masques durs, de couches barrière à la diffusion du cuivre ou de couches d'arrêt pour le polissage mécano-chimique (CMP). Le document EP 960958 mentionne l'usage des matériaux H:SiOC et SiC:H comme matériaux dielectriques dans les interconnexions.

Comme matériau diélectrique d'interface dans les structures Damascène, les matériaux SiO₂, Si₃N₄ et SiOₓN_{y} sont habituellement utilisés du fait qu'ils sont déjà couramment employés dans la réalisation des circuits intégrés. En effet, ils sont utilisés soit au niveau de la zone active des circuits en tant qu'isolants, soit au niveau des interconnexions en tant que diélectriques intermétalliques ou en tant que diélectriques de passivation. Ils peuvent être déposés par des techniques variées mais bien connues : par croissance thermique d'oxyde, par CVD basse pression (LPCVD), par CVD atmosphérique (APCVD) ou par CVD assisté par plasma (PECVD).

Les propriétés requises pour les matériaux diélectriques d'interface dans les structures Damascène sont les suivantes :
- Les matériaux à usage de barrière doivent posséder une bonne résistance à la diffusion du cuivre.
- Les matériaux à usage de masque dur doivent présenter une excellente sélectivité de gravure vis-à-vis des matériaux sous-jacents de type organique ou minéral.
- Les matériaux à usage de couche d'arrêt au polissage doivent présenter une bonne résistance au polissage mécano-chimique afin de permettre l'élimination du cuivre excédentaire au-dessus des lignes sans qu'il y ait dégradation du diélectrique. Autrement dit, ces matériaux doivent présenter une sélectivité au polissage élevée vis-à-vis du cuivre.
- Tous ces matériaux doivent de plus avoir de bonnes tenues électriques : faible constante diélectrique, faible courant de fuite.
- Les matériaux déposés directement sur les diélectriques à très faible permittivité (matériaux des masques durs et des couches d'arrêt) doivent présenter une bonne compatibilité chimique avec ces diélectriques.

Parmi les matériaux diélectriques d'interface conventionnels, SiO₂ présente de bonnes qualités électriques et une bonne sélectivité de gravure vis-à-vis des matériaux organiques. Cependant, ses propriétés sont insuffisantes sur les autres points. Si₃N₄ présente une bonne sélectivité de gravure, une bonne résistance à l'abrasion ainsi qu'à la diffusion du cuivre mais sa constante diélectrique est élevée. SiON est intermédiaire entre Si₃N₄ et SiO₂. Ainsi, aucun de ces matériaux conventionnels ne possède l'ensemble des propriétés requises.

D'autre part, certains de ces matériaux diélectriques d'interface, déposés généralement par voie PECVD à partir de gaz oxydants (O₂, N₂O, NO₂, O₃...), peuvent induire une oxydation de l'interface ou de toute la matrice du matériau à faible permittivité et ainsi dégrader ses propriétés : constante diélectrique, courant de fuite, densification avec modification de l'épaisseur, perte d'adhérence, modification chimique. Les matériaux diélectriques à très faible permittivité à base Si-O à structure poreuse, comportant des radicaux carbonés (de type SiR) ou hydrure (de type Si-H) sont particulièrement visés par ces dégradations. En effet, pour ces matériaux, lors du dépôt de la couche de matériau diélectrique d'interface, il se produit une oxydation plus ou moins profonde selon leur porosité. Cette oxydation induit la formation de silanol (Si-OH) et d'eau qui sont respectivement des radicaux ou des molécules très polaires.

Il se pose donc le problème de trouver des matériaux diélectriques permettant la réalisation de couches d'interface satisfaisant l'ensemble des propriétés requises.

### EXPOSÉ DE L'INVENTION

L'invention permet la réalisation de structures de type Damascène utilisant des diélectriques à très faible permittivité de type minéral à base Si-O ayant une structure poreuse. Ces diélectriques à très faible permittivité comportent des radicaux organiques (par exemple Si-CH₃) ou hydrures (par exemple Si-H). Il peut s'agir de xérogels, d'aérogels de méthyle ou d'hydrogène silsesquioxane ou de tout autre matériau à base d'oxyde minéral poreux pouvant comporter des radicaux organiques obtenus par étalement d'un précurseur ou par un procédé CVD. Les couches diélectriques d'interface sont formées par une association de sous-couches de SiOCH et de SiCH.

L'invention a donc pour objet un procédé de réalisation d'une structure d'interconnexions de type Damascène sur une face à connecter d'un dispositif micro-électronique, le procédé comprenant le dépôt d'au moins une couche de matériau diélectrique sur ladite face à connecter, destinée à loger lesdites interconnexions, le procédé comprenant également le dépôt d'au moins une couche d'interface en matériau diélectrique en contact intime avec ladite couche de matériau diélectrique destinée à loger les interconnexions, caractérisé en ce que ladite couche d'interface est formée par le dépôt d'au moins une sous-couche de SiOCH et d'au moins une sous-couche de SiCH.

Avantageusement, le dépôt d'une couche de matériau diélectrique destinée à loger les interconnexions consiste à déposer une couche d'un matériau choisi parmi les matériaux diélectriques à très faible permittivité de type minéral à base Si-O, comportant des radicaux organiques ou hydrures.

De préférence, la couche d'interface comprend une sous-couche en SiCH déposée sur et en contact avec la couche de matériau diélectrique destinée à loger les interconnexions, une sous-couche en SiOCH étant déposée sur et en contact avec la sous-couche en SiCH. Dans ce cas, la sous-couche de SiOCH peut être utilisée comme masque de gravure pour la sous-couche de SiCH en vue de loger les interconnexions dans la couche de matériau diélectrique correspondante.

Le dispositif micro-électronique peut être réalisé sur du silicium.

Si les interconnexions sont en cuivre, il est prévu le dépôt d'une couche métallique formant barrière à la diffusion du cuivre dans la couche de matériau diélectrique destinée à loger les interconnexions.

De manière particulière, l'invention a pour objet un procédé de réalisation d'une structure d'interconnexions de type double Damascène sur une face à connecter d'un dispositif micro-électronique réalisé sur du silicium, ladite face présentant des lignes conductrices en cuivre à connecter, caractérisé en ce qu'il comprend les étapes suivantes :
- dépôt sur ladite face à connecter d'une couche barrière à la diffusion du cuivre en SiCH,
- dépôt sur la couche barrière d'une première couche de matériau diélectrique de très faible permittivité pour le logement desdites interconnexions,
- dépôt d'une première couche d'interface sur ladite première couche de matériau diélectrique, comprenant une sous-couche de SiCH, déposée sur et en contact avec la première couche de matériau diélectrique, et une sous-couche de SiOCH,
- gravure de trous dans ladite sous-couche de SiOCH, en vis-à-vis des lignes conductrices à connecter, au moyen d'un masque de résine, jusqu'à révéler la sous-couche de SiCH,
- retrait du masque de résine,
- gravure de la partie de la sous-couche de SiCH révélée jusqu'à atteindre la première couche de matériau diélectrique,
- dépôt sur la première couche d'interface gravée d'une deuxième couche de matériau diélectrique de très faible permittivité pour le logement desdites interconnexions,
- dépôt d'une deuxième couche d'interface sur ladite deuxième couche de matériau diélectrique, comprenant successivement une première sous-couche de SiCH, déposée sur et en contact avec la deuxième couche de matériau diélectrique, une deuxième sous-couche de SiOCH et une troisième sous-couche de SiCH,
- gravure de trous dans ladite troisième sous-couche, en vis-à-vis des lignes conductrices à connecter, au moyen d'un masque de résine, jusqu'à révéler la deuxième sous-couche,
- retrait du masque de résine,
- gravure de la partie de la deuxième sous-couche révélée et de la partie de la première sous-couche révélée par la gravure de la deuxième sous-couche,
- gravure de trous au travers de la deuxième couche de matériau diélectrique, de la première couche de matériau diélectrique et de la couche barrière, lesdites couches d'interface servant de masque dur, jusqu'à révéler les lignes conductrices, ladite troisième sous-couche étant également éliminée,
- dépôt uniforme d'une couche métallique servant de barrière à la diffusion du cuivre sur l'empilement de couches gravées,
- dépôt d'une couche de cuivre remplissant les trous gravés dans la structure,
- polissage de l'excès de cuivre et de la couche métallique recouvrant la deuxième sous-couche pour révéler la deuxième sous-couche et fournir les interconnexions.

L'invention a aussi pour objet une structure d'interconnexions de type Damascène sur une face d'un dispositif micro-électronique, comprenant au moins une couche de matériau diélectrique destinée à loger lesdites interconnexions et comprenant au moins une couche d'interface en matériau diélectrique en contact intime avec ladite couche de matériau diélectrique destinée à loger les interconnexions, caractérisée en ce que ladite couche d'interface comprend au moins une sous-couche de SiOCH et au moins une sous-couche de SiCH.

Avantageusement, la couche de matériau diélectrique destinée à loger lesdites interconnexions est une couche d'un matériau choisi parmi les matériaux diélectriques à très faible permittivité de type minéral à base Si-O, comportant des radicaux organiques ou hydrures.

De préférence, la couche d'interface comprend une sous-couche en SiCH sur et en contact avec la couche de matériau diélectrique destinée à loger les interconnexions, une sous-couche en SiOCH étant disposée sur et en contact avec la sous-couche en SiCH.

Si les interconnexions sont en cuivre, la structure comprend une couche métallique formant barrière à la diffusion du cuivre dans la couche de matériau diélectrique destinée à loger les interconnexions.

De manière particulière, l'invention a pour objet une structure d'interconnexions de type double Damascène sur une face à connecter d'un dispositif micro-électronique réalisé sur du silicium, ladite face présentant des lignes conductrices en cuivre à connecter, caractérisée en ce qu'elle comprend :
- une couche barrière à la diffusion du cuivre en SiCH déposée sur ladite face,
- une première couche de matériau diélectrique de très faible permittivité déposée sur la couche barrière,
- une première couche d'interface déposée sur ladite première couche de matériau diélectrique, comprenant une sous-couche de SiCH, déposée sur et en contact avec la première couche de matériau diélectrique, et une sous-couche de SiOCH,
- une deuxième couche de matériau diélectrique de très faible permittivité déposée sur la première couche d'interface,
- une deuxième couche d'interface déposée sur ladite deuxième couche de matériau diélectrique, comprenant une première sous-couche de SiCH, déposée sur et en contact avec la deuxième couche de matériau diélectrique, et une deuxième sous-couche de SiOCH,
- des interconnexions en cuivre traversant ladite structure pour établir des liaisons électriques avec lesdites lignes conductrices, une couche barrière à la diffusion du cuivre séparant les interconnexions des couches de matériau diélectrique de très faible permittivité.

### BREVE DESCRIPTION DES DESSINS

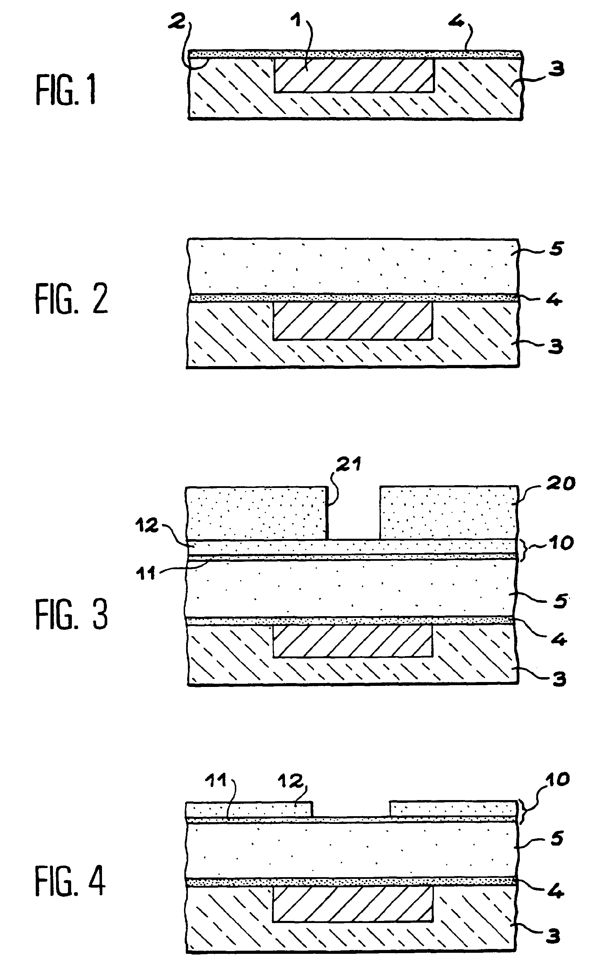

L'invention sera mieux comprise et d'autres avantages et particularités apparaîtront à la lecture de la description qui va suivre, donnée à titre d'exemple non limitatif, accompagnée des dessins annexés comprenant les figures 1 à 10 qui illustrent différentes étapes de la réalisation d'une structure d'interconnexions de type double Damascène selon la présente invention.

### DESCRIPTION DETAILLEE D'UN MODE DE REALISATION DE L'INVENTION

Comme il a été dit plus haut, l'association de sous-couches de SiOCH et de SiCH présente l'ensemble des qualités requises pour réaliser une bonne couche d'interface.

Le tableau ci-dessous compare le SiCH et le SiOCH à d'autres matériaux diélectriques utilisés couramment en micro-électronique. Les signes + et -, et leur nombre, indiquent respectivement leurs propriétés plus ou moins bonnes.

| Propriétés | Matériaux | | | | |
|---|---|---|---|---|---|
| | SiO₂ | Si₃N₄ | SiON | SiCH | SiOCH |
| Constante Diélectrique | 4,3 | 8 | 6,5 | 5,5 | 2,7 |
| Sélectivité gravure fluorée/SiO₂ | 0 | ++ | + | +++ | + |
| Résistance à l'abrasion/Cu | + | ++ | + | +++ | ++ |
| Diffusion Cu | - | ++ | - | +++ | - |
| Compatibilité chimique | --- | + | - | + | -- |

La dernière ligne du tableau concerne la compatibilité chimique entre chaque matériau du tableau avec les matériaux diélectriques destinés à loger les interconnexions.

Le tableau montre que le SiCH et le SiOCH allient à eux deux l'ensemble des qualités requises pour obtenir une bonne couche d'interface : résistance à l'abrasion, à la diffusion du cuivre et sélectivité de gravure pour le SiCH, faible constante diélectrique pour le SiOCH. D'autre part, le SiCH est réalisé sans précurseur oxydant. De plus, ces deux matériaux présentent entre eux une bonne compatibilité et peuvent être déposés dans un même réacteur à partir de précurseurs équivalents de type méthyl-, diméthyl- ou triméthylsilane, voire phénylsilane. Le SiOCH s'obtient par adjonction d'un précurseur oxydant de type O₂, N₂0, NO₂, CO₂...

Un exemple de réalisation d'une structure double Damascène va maintenant être décrit en relation avec les figures 1 à 10 qui sont des vues en coupe transversale et partielles d'une structure d'interconnexions de type double Damascène selon l'invention.

La figure 1 montre une ligne de cuivre 1 affleurant sur une face 2 d'un diélectrique 3 déposé sur un substrat semi-conducteur. On dépose sur la face 2 une couche d'interface 4 servant de couche barrière à la diffusion du cuivre. La couche 4 possède une épaisseur comprise entre 10 et 30 nm.

Comme le montre la figure 2, une couche 5 de matériau diélectrique à faible permittivité dite "diélectrique via" est déposée sur la couche 4. Son épaisseur est comprise entre 0,5 et 1 µm.

La figure 3 montre qu'une couche d'interface 10 a été déposée sur la couche de matériau diélectrique 5. La couche d'interface 10, destinée à constituer un masque dur, comprend une sous-couche 11 en SiCH déposée sur la couche de matériau diélectrique 5 et une sous-couche 12 de SiOCH déposée sur la sous-couche 11. La sous-couche 11 peut avoir une épaisseur comprise entre 10 et 20 nm tandis que l'épaisseur de la sous-couche 12 est de l'ordre de 100 nm. Cet empilement de sous-couches est compatible avec le matériau à faible permittivité de la couche 5 car SiCH n'oxyde pas le diélectrique et permet de garantir une excellente sélectivité de gravure : masque dur / diélectrique à faible permittivité.

En vue de permettre ultérieurement une liaison électrique avec la ligne 1, une couche de résine photosensible 20 est déposée sur la couche d'interface ou masque dur 10 et un trou de gravure 21 y est défini en vis-à-vis de la ligne 1.

La gravure du masque dur 10 se fait en trois opérations. Un trou est d'abord gravé dans la sous-couche 12 en SiOCH jusqu'à révéler la sous-couche 11 en SiCH. La couche de résine 20 est ensuite retirée, la couche de diélectrique via 5, qui est très sensible à l'oxydation produite par les agents oxydants de retrait de résine (plasma O₂, bases organiques, etc.), étant alors protégée par la sous-couche 11 comme le montre la figure 4. Enfin, la sous-couche 11 est gravée en se servant de la sous-couche 12 comme masque, la sous-couche 12 étant partiellement gravée.

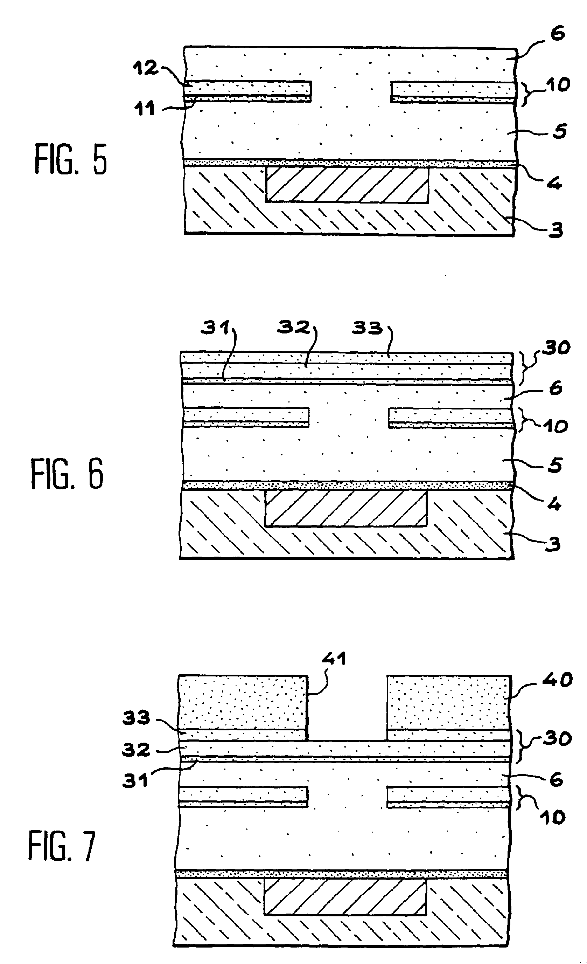

Comme le montre la figure 5, une couche 6 de matériau diélectrique à faible permittivité dite "diélectrique ligne" est déposée sur la couche d'interface 10 et comble le trou réalisé sur la couche d'interface 10. L'épaisseur de la couche 6 peut être comprise entre 0,3 et 0,6 µm.

Une couche d'interface 30 est alors déposée sur la couche de matériau diélectrique 6 comme le montre la figure 6. La couche d'interface 30 comprend trois sous-couches : dans l'ordre de dépôt une sous-couche 31 en SiCH d'épaisseur inférieure à 10 nm et compatible avec le matériau diélectrique de la couche 6, une sous-couche 32 en SiOCH d'une épaisseur comprise entre 100 et 150 nm et une sous-couche 33 en SiCH d'épaisseur légèrement supérieure à la somme des épaisseurs de la couche 2 et de la sous-couche 31 en SiCH. La couche d'interface 30 servira de couche d'arrêt au polissage mécano-chimique et aussi de masque dur. La sous-couche 31 sert en particulier à éviter l'oxydation de la couche de diélectrique 6. La sous-couche 32 sert de couche d'arrêt au polissage. Elle protège la couche de diélectrique 6 des défauts d'uniformités de polissage. Elle permet de limiter l'effet du retrait de cuivre lors de l'étape de polissage mécano-chimique. La sous-couche 33 sert de contre-masque de gravure permettant de graver en une seule étape un trou révélant la ligne 1.

Comme le montre la figure 7, une couche de résine photosensible 40 est déposée sur la couche d'interface 30 et un trou de gravure 41 y est défini en vis-à-vis du trou précédemment gravé dans le masque dur 10. Un trou est d'abord gravé dans la sous-couche 33 en SiCH avec arrêt dans la sous-couche 32 en SiOCH. La résine est alors retirée, le matériau diélectrique de la couche 6 étant protégé par les sous-couches 31 et 32.

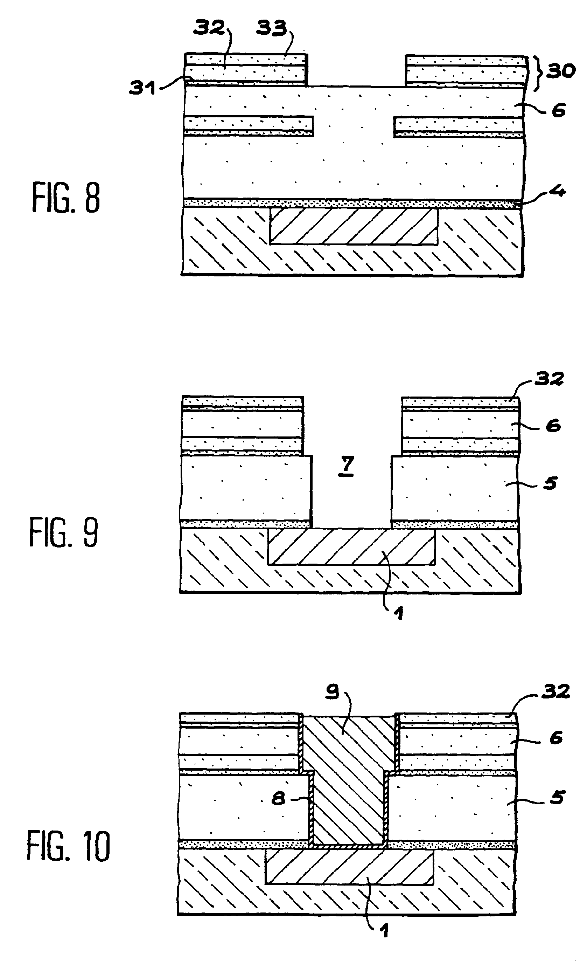

Comme le montre la figure 8, la gravure du masque dur 30 est poursuivie jusqu'à révéler la couche de diélectrique ligne 6. La sous-couche 33 en SiCH est gravée sur toute sa surface sur une épaisseur au moins équivalente à l'épaisseur de la sous-couche 31 en SiCH.

Le matériau diélectrique à faible permittivité des couches 5 et 6 est ensuite gravé au travers des trous réalisés dans les masques durs 10 et 30 jusqu'à atteindre la couche 4 en SiCH servant de couche barrière à la diffusion du cuivre. A ce niveau, le reste de la sous-couche 33 en SiCH ainsi que la couche 4 en SiCH au fond du trou gravé 7 sont gravés en même temps. La ligne 1 est ainsi révélée comme le montre la figure 9.

Une couche 8 en nitrure de titane ou en nitrure de tantale, servant de barrière métallique de diffusion, est déposée uniformément sur la structure. Cette couche adhère également sur les parois et sur le fond du trou 7 qui est ensuite rempli de cuivre. Le cuivre et la barrière métallique en excès sont ensuite polis avec arrêt dans la sous-couche 32 en SiOCH. On obtient la structure représentée à la figure 10 qui montre la présence d'une connexion en cuivre 9 traversant la couche de diélectrique via 5 et la couche de diélectrique ligne 6 pour prendre contact avec la ligne 1.

L'exemple suivant va montrer tout l'intérêt de la structure selon l'invention. On suppose que la couche 6 (diélectrique ligne) a une épaisseur de 0,4 µm et possède une constante diélectrique égale à 2, que la sous-couche d'arrêt 31 en SiCH a une épaisseur de 5 nm, que la sous-couche 32 en SiOCH a une épaisseur de 50 nm après polissage et que la sous-couche 12 en SiOCH a une épaisseur de 50 nm. Dans ces conditions, la constante diélectrique équivalente à cet empilement est de 2,25. A titre de comparaison, l'emploi de SiN à la place du SiCH et l'emploi de SiO₂ à la place du SiOCH conduirait à une constante diélectrique équivalente de 2,55.

## Revendications

1. Procédé de réalisation d'une structure d'interconnexions de type Damascène sur une face (2) à connecter d'un dispositif micro-électronique, le procédé comprenant le dépôt d'au moins une couche de matériau diélectrique (5, 6) sur ladite face (2) à connecter, destinée à loger lesdites interconnexions (9), le procédé comprenant également le dépôt d'au moins une couche d'interface (10, 30) en matériau diélectrique en contact intime avec ladite couche de matériau diélectrique (5, 6) destinée à loger les interconnexions (9), **caractérisé en ce que** ladite couche d'interface (10, 30) est formée par le dépôt d'au moins une sous-couche (12, 32) de SiOCH et d'au moins une sous-couche de SiCH (11, 31, 33).

2. Procédé selon la revendication 1, **caractérisé en ce que** le dépôt d'une couche de matériau diélectrique (5, 6) destinée à loger les interconnexions (9) consiste à déposer une couche d'un matériau choisi parmi les matériaux diélectriques à très faible permittivité de type minéral à base Si-O, comportant des radicaux organiques ou hydrures.

3. Procédé selon l'une des revendications 1 ou 2, **caractérisé en ce que** la couche d'interface (10, 30) comprend une sous-couche en SiCH (11, 31) déposée sur et en contact avec la couche de matériau diélectrique (5, 6) destinée à loger les interconnexions (9), une sous-couche en SiOCH (12, 32) étant déposée sur et en contact avec la sous-couche en SiCH (11, 31).

4. Procédé selon l'une quelconque des revendications 1 à 3, **caractérisé en ce que** le dispositif micro-électronique est réalisé sur du silicium (3).

5. Procédé selon l'une quelconque des revendications 1 à 4, **caractérisé en ce que** les interconnexions (9) étant en cuivre, il est prévu le dépôt d'une couche métallique (8) formant barrière à la diffusion du cuivre dans la couche de matériau diélectrique (5, 6) destinée à loger les interconnexions.

6. Procédé selon la revendication 3, **caractérisé en ce que** la sous-couche de SiOCH (12) est utilisée comme masque de gravure pour la sous-couche de SiCH (11) en vue de loger les interconnexions (9) dans la couche de matériau diélectrique correspondante.

7. Procédé de réalisation d'une structure d'interconnexions de type double Damascène sur une face (2) à connecter d'un dispositif micro-électronique réalisé sur du silicium, ladite face (2) présentant des lignes conductrices en cuivre (1) à connecter, **caractérisé en ce qu'**il comprend les étapes suivantes :
- dépôt sur ladite face (2) à connecter d'une couche barrière à la diffusion du cuivre (4) en SiCH,
- dépôt sur la couche barrière (4) d'une première couche de matériau diélectrique de très faible permittivité (5) pour le logement desdites interconnexions,
- dépôt d'une première couche d'interface (10) sur ladite première couche de matériau diélectrique (5), comprenant une sous-couche (11) de SiCH, déposée sur et en contact avec la première couche de matériau diélectrique, et une sous-couche (12) de SiOCH,
- gravure de trous dans ladite sous-couche (12) de SiOCH, en vis-à-vis des lignes conductrices (1) à connecter, au moyen d'un masque de résine (20), jusqu'à révéler la sous-couche (11) de SiCH,
- retrait du masque de résine (20),
- gravure de la partie de la sous-couche (11) de SiCH révélée jusqu'à atteindre la première couche de matériau diélectrique (5),
- dépôt sur la première couche d'interface (10) gravée d'une deuxième couche de matériau diélectrique de très faible permittivité (6) pour le logement desdites interconnexions,
- dépôt d'une deuxième couche d'interface (30) sur ladite deuxième couche de matériau diélectrique (6), comprenant successivement une première sous-couche (31) de SiCH, déposée sur et en contact avec la deuxième couche de matériau diélectrique (6), une deuxième sous-couche (32) de SiOCH et une troisième sous-couche (33) de SiCH,
- gravure de trous dans ladite troisième sous-couche (33), en vis-à-vis des lignes conductrices (1) à connecter, au moyen d'un masque de résine (40), jusqu'à révéler la deuxième sous-couche (32),
- retrait du masque de résine (40),
- gravure de la partie de la deuxième sous-couche (32) révélée et de la partie de la première sous-couche (31) révélée par la gravure de la deuxième sous-couche (32),
- gravure de trous (7) au travers de la deuxième couche de matériau diélectrique (6), de la première couche de matériau diélectrique (5) et de la couche barrière (4), lesdites couches d'interface (30, 10) servant de masque dur, jusqu'à révéler les lignes conductrices (1), ladite troisième sous-couche (33) étant également éliminée,
- dépôt uniforme d'une couche métallique (8) servant de barrière à la diffusion du cuivre sur l'empilement de couches gravées,
- dépôt d'une couche de cuivre remplissant les trous (7) gravés dans la structure,
- polissage de l'excès de cuivre et de la couche métallique (8) recouvrant la deuxième sous-couche (32) pour révéler la deuxième sous-couche (32) et fournir les interconnexions (9).

8. Structure d'interconnexions de type Damascène sur une face d'un dispositif micro-électronique, comprenant au moins une couche de matériau diélectrique (5, 6) destinée à loger lesdites interconnexions (9) et comprenant au moins une couche d'interface (10) en matériau diélectrique en contact intime avec ladite couche de matériau diélectrique destinée à loger les interconnexions, **caractérisée en ce que** ladite couche d'interface (10) comprend au moins une sous-couche de SiOCH (12) et au moins une sous-couche de SiCH (11).

9. Structure d'interconnexions selon la revendication 8, **caractérisée en ce que** la couche de matériau diélectrique (5, 6) destinée à loger lesdites interconnexions (9) est une couche d'un matériau choisi parmi les matériaux diélectriques à très faible permittivité de type minéral à base Si-O, comportant des radicaux organiques ou hydrures.

10. Structure d'interconnexions selon l'une des revendications 8 ou 9, **caractérisée en ce que** la couche d'interface (10) comprend une sous-couche (11) en SiCH sur et en contact avec la couche de matériau diélectrique (5) destinée à loger les interconnexions, une sous-couche (12) en SiOCH étant disposée sur et en contact avec la sous-couche (11) en SiCH.

11. Structure d'interconnexions selon l'une quelconque des revendications 8 à 10, **caractérisée en ce que** le dispositif micro-électronique est un dispositif réalisé sur du silicium (3).

12. Structure d'interconnexions selon l'une quelconque des revendications 8 à 11, **caractérisée en ce que** les interconnexions (9) étant en cuivre, la structure comprend une couche métallique (8) formant barrière à la diffusion du cuivre dans la couche de matériau diélectrique (5, 6) destinée à loger les interconnexions (9).

13. Structure d'interconnexions de type double Damascène sur une face (2) à connecter d'un dispositif micro-électronique réalisé sur du silicium, ladite face (2) présentant des lignes conductrices (1) en cuivre à connecter, **caractérisée en ce qu'**elle comprend :
- une couche barrière à la diffusion du cuivre (4) en SiCH déposée sur ladite face (2),
- une première couche de matériau diélectrique de très faible permittivité (5) déposée sur la couche barrière (4),
- une première couche d'interface (10) déposée sur ladite première couche de matériau diélectrique (5), comprenant une sous-couche (11) de SiCH, déposée sur et en contact avec la première couche de matériau diélectrique (5), et une sous-couche (12) de SiOCH,
- une deuxième couche de matériau diélectrique de très faible permittivité (6) déposée sur la première couche d'interface (10),
- une deuxième couche d'interface (30) déposée sur ladite deuxième couche de matériau diélectrique (6), comprenant une première sous-couche (31) de SiCH, déposée sur et en contact avec la deuxième couche de matériau diélectrique (6), et une deuxième sous-couche (32) de SiOCH,
- des interconnexions (9) en cuivre traversant ladite structure pour établir des liaisons électriques avec lesdites lignes conductrices (1), une couche barrière à la diffusion du cuivre (8) séparant les interconnexions (9) des couches de matériau diélectrique de très faible permittivité (5, 6).

## Claims

1. Process for the production of a damaskeen-type interconnection structure on a face (2) to be connected of a microelectronic device, comprising the deposition of at least one dielectric material layer (5, 6) on said face (2) to be connected and which is to house said interconnections (9), the process also comprising the deposition of at least one dielectric material interface layer (10, 30) in intimate contact with said dielectric material layer (5, 6) for housing the interconnections (9), **characterized in that** said interface layer (10, 30) is formed by the deposition of at least one Si0CH sublayer (12, 32) and at least one SiCH sublayer (11, 31, 33).

2. Process according to claim 1, **characterized in that** the deposition of a dielectric material layer (5, 6) for housing the interconnections (9) consists of depositing a layer of a material chosen from among very low permittivity dielectric materials of the mineral type based on Si-0, having organic radicals or hydrides.

3. Process according to one of the claims 1 or 2, **characterized in that** the interface layer (10, 30) comprises a SiCH sublayer (11, 31) deposited on and in contact with the dielectric material layer (5, 6) for housing the interconnections (9), a Si0CH sublayer (12, 32) being deposited on and in contact with the SiCH sublayer (11, 31).

4. Process according to any one of the claims 1 to 3, **characterized in that** the microelectronic device is produced on silicon (3).

5. Process according to any one of the claims 1 to 4, **characterized in that** with the interconnections (9) made from copper, deposition takes place of a metal layer (8) forming a barrier to the diffusion of copper into the dielectric material layer (5, 6) for housing the interconnections.

6. Process according to claim 3, **characterized in that** the Si0CH sublayer (12) is used as the etching mask for the SiCH sublayer (11) for housing the interconnections (9) in the corresponding dielectric material layer.

7. Process for the production of a double damaskeen-type interconnection structure on a face (2) to be connected of a microelectronic device produced on silicon, said face (2) having copper conductive lines (1) to be connected, **characterized in that** it comprises the following steps:
- deposition on the face (2) to be connected of a barrier layer (4) to the diffusion of copper into SiCH,
- deposition on the barrier layer (4) of a first very low permittivity dielectric material layer (5) for housing said interconnections,
- deposition of a first interface layer (10) on said first dielectric material layer (5), comprising a SiCH sublayer (11) deposited on and in contact with the first dielectric material layer and a Si0CH sublayer (12),
- etching holes in said Si0CH sublayer (12) facing the conductive lines (1) to be connected by means of a resin mask (20) until the SiCH sublayer (11) is revealed,
- removal of the resin mask (20),
- etching that part of the SiCH sublayer (11) which has been revealed until the first dielectric material layer (5) is reached,
- deposition on the first etched interface layer (10) of a second very low permittivity dielectric material layer (6) for the housing of said interconnections,
- deposition of a second interface layer (30) on said second dielectric material layer (6), successively comprising a first SiCH sublayer (31) deposited on and in contact with the second dielectric material layer (6), a second Si0CH sublayer (32) and a third SiCH sublayer (33),
- etching holes in said third sublayer (33) facing the conductive lines (1) to be connected by means of a resin mask (40) until the second sublayer (32) is revealed,
- removal of the resin mask (40),
- etching that part of the second sublayer (32) which has been revealed and that part of the first sublayer (31) revealed by the etching of the second sublayer (32),
- etching holes (7) through the second dielectric material layer (6), the first dielectric material layer (5) and the barrier layer (4), said interface layers (30, 10) serving as a hard mask, up to the revealing of the conductive lines (1), said third sublayer (33) also being eliminated,
- uniform deposition of a metal layer (8) serving as a barrier to the diffusion of copper onto the stack of etched layers,
- deposition of a copper layer filling the holes (7) etched in the structure,
- polishing the excess copper and metal layer (8) covering the second sublayer (32) for revealing the second sublayer (32) and supplying the interconnections (9).

8. Damaskeen-type interconnection structure on one face of a microelectronic device, comprising at least one dielectric material layer (5, 6) for housing said interconnections (9) and at least one dielectric material interface layer (10) in intimate contact with said dielectric material layer for housing the interconnections, **characterized in that** said interface layer (10) comprises at least one Si0CH sublayer (12) and at least one SiCH sublayer (11).

9. Interconnection structure according to claim 8, **characterized in that** the dielectric material layer (5, 6) for housing said interconnections (9) is a layer of a material chosen from among very low permittivity dielectric materials of the mineral type based on Si-0 and having organic radicals or hydrides.

10. Interconnection structure according to one of the claims 8 or 9, **characterized in that** the interface layer (10) comprises a SiCH sublayer (11) on and in contact with the dielectric material layer (5) for housing the interconnections, a Si0CH sublayer (12) being deposited on and in contact with the SiCH sublayer (11).

11. Interconnection structure according to any one of the claims 8 to 10, **characterized in that** the microelectronic device is a device produced on silicon (3).

12. Interconnection structure according to any one of the claims 8 to 11, **characterized in that** the interconnections (9) are of copper, the structure comprising a metal layer (8) forming a barrier to the diffusion of copper into the dielectric material layer (5, 6) for housing the interconnections (9).

13. Double damaskeen-type interconnection structure on a face (2) to be connected of a microelectronic device produced on silicon, said face (2) having copper conductive lines (1) to be connected, **characterized in that** it comprises:
- a barrier layer (4) to the diffusion of copper into the SiCH deposited on said face (2),
- a first very low permittivity dielectric material layer (5) deposited on the barrier layer (4),
- a first interface layer (10) deposited on said first dielectric material layer (5), comprising a SiCH sublayer (11) deposited on and in contact with the first dielectric material layer (5) and a Si0CH sublayer (12),
- a second very high permittivity dielectric material layer (6) deposited on the first interface layer (10),
- a second interface layer (30) deposited on the second dielectric material layer (6) and comprising a first SiCH sublayer (31) deposited on and in contact with the second dielectric material layer (6) and a second Si0CH sublayer (32),
- copper interconnections (9) traversing said structure for establishing electrical connections with said conductive lines (1), a barrier layer to the diffusion of copper (8) separating the interconnections (9) from the very low permittivity dielectric material layers (5, 6).

## Patentansprüche

1. Verfahren zur Herstellung einer Verbindungsstruktur vom Damaszener-Typ auf einer Fläche (2), die mit einer mikroelektronischen Vorrichtung zu verbinden ist, wobei das Verfahren die Aufbringung mindestens einer Schicht dielektrischen Materials (5,6) auf die zu verbindende Fläche (2) umfasst, die zur Aufnahme der Verbindungen (9) bestimmt ist, wobei das Verfahren auch die Aufbringung mindestens einer Grenzflächenschicht (10,30) aus dielektrischem Material in engem Kontakt mit der Schicht dielektrischen Materials (5,6), die zur Aufnahme der Verbindungen (9) bestimmt ist, umfasst, **dadurch gekennzeichnet, dass** die Grenzflächenschicht (10,30) durch die Aufbringung mindestens einer Unterschicht (12,32) aus SiOCH und mindestens einer Unterschicht aus SiCH (11,31,33) gebildet wird.

2. Verfahren nach Anspruch 1, **dadurch gekennzeichnet, dass** die Aufbringung einer dielektrischen Materialschicht (5,6), die zur Aufnahme der Verbindungen (9) bestimmt ist, darin besteht, eine Schicht eines Materials aufzubringen, das aus den dielektrischen Materialien mit sehr geringer Dielektrizitätskonstante vom Mineraltyp auf Si-O-Basis, das organische oder Wasserstoff-Reste umfasst, ausgewählt wird.

3. Verfahren nach einem der Ansprüche 1 oder 2, **dadurch gekennzeichnet, dass** die Grenzflächenschicht (10,30) eine Unterflächenschicht aus SiCH (11,31) umfasst, die auf die dielektrische Materialschicht (5,6), die zur Aufnahme der Verbindungen (9) bestimmt ist, aufgebracht wird und in Kontakt mit dieser kommt, eine Unterschicht aus SiOCH (12,32), die auf die Unterschicht aus SiCH (11,31) aufgebracht wird und in Kontakt mit dieser kommt.

4. Verfahren nach einem der Ansprüche 1 bis 3, **dadurch gekennzeichnet, dass** die mikroelektronische Vorrichtung auf Silizium (3) hergestellt wird.

5. Verfahren nach einem der Ansprüche 1 bis 4, **dadurch gekennzeichnet, dass** bei den aus Kupfer bestehenden Verbindungen (9) die Aufbringung einer Metallschicht (8) vorgesehen ist, die eine Sperre gegen eine Diffusion des Kupfers in die zur Aufnahme der Verbindungen vorgesehene dielektrische Materialschicht (5,6) bildet.

6. Verfahren nach Anspruch 3, **dadurch gekennzeichnet, dass** die Unterschicht aus SiOCH (12) als Ätzabdeckung für die Unterschicht aus SICH (11) verwendet wird, um die Verbindungen (9) in der entsprechenden dielektrischen Materialschicht aufzunehmen.

7. Verfahren zur Herstellung einer Verbindungsstruktur vom Doppel-Damaszener-Typ auf einer Fläche (2), die mit einer auf Silizium hergestellten mikroelektronischen Vorrichtung zu verbinden ist, wobei die Fläche (2) zu verbindende Leiterbahnen aus Kupfer (1) aufweist, **dadurch gekennzeichnet, dass** es die folgenden Schritte umfasst:
- Aufbringung einer Diffusionssperrschicht für Kupfer (4) aus SiCH auf die zu verbindende Fläche (2),
- Aufbringung einer ersten Schicht aus dielektrischem Material mit geringer Dielektrizitätskonstante (5) für die Aufnahme der Verbindungen auf die Sperrschicht (4),
- Aufbringung einer Grenzflächenschicht (10) auf die erste dielektrische Materialschicht (5), mit einer Unterschicht (11) aus SiCH, die auf die erste dielektrische Materialschicht aufgebracht wird und in Kontakt mit dieser kommt, und einer Unterschicht (12) aus SiOCH,
- Ätzen von Löchern in die Unterschicht (12) aus SiOCH gegenüber den zu verbindenden Leiterbahnen (1) mittels einer Harzabdeckung (20), bis die Unterschicht (11) aus SiCH freiliegt,
- Abnehmen der Harzabdeckung (20),
- Ätzen des entwickelten Abschnitts der Unterschicht (11) aus SiCH bis zum Erhalt der ersten dielektrischen Materialschicht (5),
- Aufbringung einer zweiten dielektrischen Materialschicht mit geringer Dielektrizitätskonstante (6) für die Aufnahme der Verbindungen auf die erste geätzte Grenzflächenschicht (10),
- Aufbringung einer zweiten Grenzflächenschicht (30) auf die zweite dielektrische Materialschicht (6), nacheinander umfassend eine erste Unterschicht (31) aus SiCH, die auf die zweite dielektrische Materialschicht (6) aufgebracht wird und mit dieser in Kontakt steht, sowie eine zweite Unterschicht (32) aus SiOCH und eine dritte Unterschicht (33) aus SiCH,
- Ätzen von Löchern in die dritte Unterschicht (33) gegenüber den zu verbindenden Leiterbahnen (1) mittels einer Harzabdeckung (40), bis die zweite Unterschicht (32) freiliegt bzw. entwickelt ist,
- Abnehmen der Harzabdeckung (40),
- Ätzen des Abschnitts der zweiten entwickelten Unterschicht (32) und des Abschnitts der ersten entwickelten Unterschicht (31) durch Ätzen der zweiten Unterschicht (32),
- Ätzen der Löcher (7) über die zweite dielektrische Materialschicht (6), die erste dielektrische Materialschicht (5) und die Sperrschicht (4) hinweg, wobei die Grenzflächenschichten (30,10) als harte Abdeckung dienen, bis die Leiterbahnen (1) entwickelt bzw. freigelegt sind, wobei die dritte Unterschicht (33) ebenfalls entfernt wird,
- gleichmäßige Aufbringung einer Metallschicht (8), die als Diffusionssperre für Kupfer auf der Schichtung geätzter Schichten dient,
- Aufbringung einer Kupferschicht, welche die in die Struktur eingeätzten Löcher (7) füllt,
- Polieren des überschüssigen Kupfers und der Metallschicht 8, welche die zweite Unterschicht (32) bedeckt, um die zweite Unterschicht (32) freizulegen und die Verbindungen (9) herzustellen.

8. Verbindungsstruktur von Damaszener Typ auf einer Fläche einer mikroelektronischen Vorrichtung mit mindestens einer dielektrischen Materialschicht (5,6), die zur Aufnahme der Verbindungen (9) bestimmt ist und mindestens eine Grenzflächenschicht (10) aus dielektrischem Material in engem Kontakt mit der zur Aufnahme der Verbindungen bestimmten dielektrischen Materialschicht umfasst, **dadurch gekennzeichnet, dass** die Grenzflächenschicht (10) mindestens eine Unterschicht aus SiOCH (12) und mindestens eine Unterschicht aus SiCH (11) umfasst.

9. Verbindungsstruktur nach Anspruch 8, **dadurch gekennzeichnet, dass** die zur Aufnahme der Verbindungen (9) bestimmte dielektrische Materialschicht (5,6) eine Schicht aus einem Material ist, das aus den dielektrischen Materialien mit sehr geringer Dielektrizitätskonstante vom Mineraltyp auf Si-O-Basis, die organische oder Wasserstoff-Reste aufweist, ausgewählt ist.

10. Verbindungsstruktur nach einem der Ansprüche 8 oder 9, **dadurch gekennzeichnet, dass** die Grenzflächenschicht (10) eine Unterschicht (11) aus SiCH auf der zur Aufnahme der Verbindungen bestimmten dielektrischen Materialschicht (5) umfasst, die mit dieser in Kontakt steht, sowie eine Unterschicht (12) aus SiOCH, die auf der Unterschicht (11) aus SiCH angeordnet ist und mit dieser in Kontakt steht.

11. Verbindungsstruktur nach einem der Ansprüche 8 bis 10, **dadurch gekennzeichnet, dass** die mikroelektronische Vorrichtung eine aus Silizium (3) hergestellte Vorrichtung ist.

12. Verbindungsstruktur nach einem der Ansprüche 8 bis 11, **dadurch gekennzeichnet, dass** die Verbindungen (9) aus Kupfer sind und die Struktur eine Metallschicht (8) umfasst, die eine Diffusionssperre für Kupfer in der zur Aufnahme der Verbindungen (9) bestimmten dielektrischen Materialschicht (5,6) bildet.

13. Verbindungsstruktur vom Doppel-Damaszener-Typ, auf einer zu verbindenden Fläche (2) einer auf Silizium hergestellten mikroelektronischen Vorrichtung, wobei die Fläche (2) zu verbindende Leiterbahnen (1) aus Kupfer aufweist, **dadurch gekennzeichnet, dass** sie umfasst:
- eine Diffusionssperrschicht für Kupfer (4) aus auf die Fläche (2) aufgebrachtem SiCH,
- eine erste dielektrische Materialschicht sehr geringer Dielektrizitätskonstante (5), die auf die Sperrschicht (4) aufgebracht ist,
- eine erste Grenzflächenschicht (10), die auf die erste dielektrische Materialschicht (5) aufgebracht ist und eine Unterschicht (11) aus SiCH umfasst, die auf die erste dielektrische Materialschicht (5) aufgebracht ist und mit dieser in Kontakt steht, sowie eine Unterschicht (12) aus SiOCH,
- eine zweite dielektrische Materialschicht (6) sehr geringer Dielektrizitätskonstante, die auf die erste Grenzflächenschicht (10) aufgebracht ist,
- eine zweite Grenzflächenschicht (30), die auf die zweite dielektrische Materialschicht (6) aufgebracht ist, umfassend eine erste Unterschicht (31) aus SiCH, die auf die zweite dielektrische Materialschicht (6) aufgebracht ist und mit dieser in Kontakt steht, sowie eine zweite Unterschicht (32) aus SiOCH,
- Verbindungen (9) aus Kupfer, welche die Struktur durchsetzen, um elektrische Verbindungen mit den Leiterbahnen (1) herzustellen, wobei eine Diffusionssperrschicht für Kupfer (8) die Verbindungen (9) von den dielektrischen Materialschichten mit sehr geringer Dielektrizitätskonstante (5,6) trennt.
